# EUROPEAN PATENT APPLICATION

(11) **EP 4 667 625 A1**
(43) Date of publication of application: **24.12.2025**
(21) Application number: 24756942.9
(22) Date of filing: 15.02.2024
(51) Int. Cl.: C25B 11/073, B01J 31/10, B01J 37/02, B01J 37/12, C07C 1/02, C07C 11/04, C23C 20/08, C25B 1/23, C25B 3/03, C25B 3/07, C25B 3/26, C25B 9/00, C25B 11/031, C25B 11/052, C25B 11/055, C25B 11/061, C25B 11/065

(54) **CATHODE ELECTRODE, COMPOSITE BODY OF CATHODE ELECTRODE AND BASE MATERIAL, ELECTROLYTIC REDUCTION DEVICE PROVIDED WITH CATHODE ELECTRODE, AND METHOD FOR PRODUCING COMPOSITE BODY OF CATHODE ELECTRODE AND BASE MATERIAL**

(30) Priority: 17.02.2023 JP 2023023853
(71) Applicant: Chiyoda Corporation, Kanagawa 220-8765 (JP); The University of Tokyo, Bunkyo-ku, Tokyo 113-8654 (JP)
(72) Inventor: MITSUHASHI, Yuri, Tokyo 100-8322 (JP); YAMAMOTO, Takahiro, Tokyo 100-8322 (JP); MIMURA, Yu, Tokyo 100-8322 (JP); YAMAMOTO, Kiyoshi, Tokyo 100-8322 (JP); SUGIYAMA, Masakazu, Tokyo 113-8654 (JP); MINEGISHI, Tsutomu, Tokyo 113-8654 (JP); TAKEDA, Dai, Yokohama-shi, Kanagawa 220-8765 (JP); MATSUMOTO, Jun, Yokohama-shi, Kanagawa 220-8765 (JP)
(74) Representative: Gulde & Partner
(86) International application number: PCT/JP2024/005169
(87) International publication number: WO 2024/172102

(57) **Abstract**

The present invention aims to provide a cathode electrode which reduces selectivity of hydrogen and enables a catalytic reaction for producing olefinic hydrocarbons such as ethylene and alcohols such as ethanol through the carbon dioxide reduction reaction to be stably sustained with high efficiency over a long period.

A cathode electrode which electrically reduces carbon dioxide, the cathode electrode comprising copper, wherein the copper is surface-modified with a cation exchange substance substituted with a metal ion.

## Description

### Technical Field

The present invention relates to a cathode electrode capable of electrically reducing carbon dioxide to convert it into carbon monoxide, olefinic hydrocarbons such as ethylene, and/or alcohols, a composite body of the cathode electrode and a base material, an electrolytic reduction device provided with the cathode electrode, and a method for producing the composite body of the cathode electrode and the base material.

### Background Art

In recent years, the adverse effects of global warming have brought about changes in the global environment, giving rise to numerous problematic phenomena. One of the causes of these changes in the global environment is considered to be the increase in the concentration of greenhouse gases in the atmosphere, particularly carbon dioxide, which constitutes a large portion of greenhouse gases. To reduce the atmospheric carbon dioxide concentration, not only increasing photosynthesis by new terrestrial afforestation and marine algae but also actively absorbing and recovering atmospheric carbon dioxide are being considered. Furthermore, in addition to merely absorbing and recovering carbon dioxide, utilizing carbon derived from carbon dioxide as a raw material for organic compounds is also being considered.

Specifically, converting carbon dioxide by reduction into, for example, C2 compounds such as ethylene and ethanol, and C1 compounds such as carbon monoxide, methane, methanol, and formic acid, for use in the synthesis of organic compounds is being considered. Among these, ethylene and ethanol, which are C2 compounds, are particularly useful as derivatives for synthesizing various organic compounds and have higher utility value than C1 compounds such as carbon monoxide and methane.

In recent years, catalysts such as photocatalysts and electrode catalysts have been widely used for the carbon dioxide reduction reaction as described above, and the development of catalysts with even better performance is sought. Catalysts used for the reduction of carbon dioxide are required to have not only high reaction efficiency but also selectivity for specific reactions. From this perspective, the selection of the catalyst material is important (Non-patent Literature 1). For example, gold, silver, and zinc are used as catalyst materials to efficiently produce carbon monoxide by reduction and to increase the proportion of carbon monoxide in the reduced substances. Further, copper is used as a catalyst material to efficiently produce hydrocarbons such as methane, ethane, and ethylene by reduction. In particular, copper has attracted attention as a cathode reduction electrode catalyst for carbon dioxide because it can produce C2 compounds such as ethylene.

As a cathode reduction electrode for carbon dioxide using copper, for example, a cathode structure has been proposed in which a coating containing one or more selected from the group consisting of alkali metals, alkaline earth metals, lanthanides, actinides, transition metals, post-transition metals, and non-metals, oxides and/or their alloys, mixed metal oxides, and ion-conducting polymers is present on a cathode material containing copper (Patent Literature 1). On the other hand, Patent Literature 1 merely discloses reducing carbon dioxide to convert it into organic compounds such as formic acid for extraction, and it has not been verified whether the catalytic reaction for synthesizing organic compounds such as ethylene can be stably sustained with high selectivity of ethylene and the like over a long period.

For industrial applications of producing organic compounds such as ethylene through the carbon dioxide reduction reaction, it is required that the catalytic reaction for producing organic compounds such as ethylene sustainably and stably maintains high selectivity of organic compounds such as ethylene over several hundred hours. The cathode structure in Patent Literature 1 had room for improvement in its ability to stably maintain a highly efficient catalytic reaction for producing organic compounds such as ethylene over a long period.

In addition, in a cathode electrode for carbon dioxide reduction, to obtain excellent synthesis efficiency of organic compounds such as ethylene, it is necessary for the carbon dioxide reduction reaction to be dominant over the hydrogen generation resulting from a side reaction (water decomposition reaction), thereby decreasing the selectivity of hydrogen and increasing the selectivity of carbon dioxide reduction products. However, in Patent Literature 1, there is no verification regarding the decrease in selectivity of hydrogen and the increase in the selectivity of carbon dioxide reduction products during carbon dioxide reduction. The cathode structure in Patent Literature 1 also had room for improvement in terms of the decrease in selectivity of hydrogen and the increase in selectivity of carbon dioxide reduction products.

### Citation List

### Patent Literature

Patent Literature 1: Japanese Unexamined Patent Application Publication (Translation of PCT Application) No. 2021-516290

### Non-Patent Literature

Non-Patent Literature 1: Y. Hori, "Electrochemical reduction of CO at a Copper Electrode", J. Phys. Chem. B. 101(36), 7075-7081 (1997)

### Summary of Invention

### Technical Problem

In view of the above circumstances, the present invention aims to provide a cathode electrode which reduces selectivity of hydrogen and enables a catalytic reaction for producing olefinic hydrocarbons such as ethylene and alcohols such as ethanol through the carbon dioxide reduction reaction to be stably sustained with high efficiency over a long period, a composite body of the cathode electrode and a base material, an electrolytic reduction device provided with the cathode electrode, and a method for producing the composite body of the cathode electrode and the base material.

### Solution to Problem

The gist of the constitution of the present invention is as follows.
[1] A cathode electrode which electrically reduces carbon dioxide, the cathode electrode comprising copper, wherein the copper is surface-modified with a cation exchange substance substituted with a metal ion.
[2] The cathode electrode of [1], wherein the copper comprises: divalent copper; and zero-valent copper and/or monovalent copper.
[3] The cathode electrode of [1], wherein the copper comprises: monovalent copper and/or divalent copper for reduction, which is reduced to zero-valent copper by a reduction treatment; and monovalent copper and/or divalent copper, which is not reduced to zero-valent copper.
[4] The cathode electrode of any one of [1] to [3], further comprising at least one additive element selected from a group consisting of silver, gold, cadmium, tin, aluminum, boron, gallium, zinc, titanium, and silicon.
[5] The cathode electrode of [4], wherein 0.10 atomic% or more and 1.0 atomic% or less of the additive element is comprised with respect to 100 atomic% of the copper.
[6] The cathode electrode of [4], wherein 0.25 atomic% or more and 0.70 atomic% or less of the additive element is comprised with respect to 100 atomic% of the copper.
[7] The cathode electrode of [4], wherein the additive element comprises aluminum.
[8] The cathode electrode of any one of [1] to [3], wherein the cation exchange substance comprises a sulfonated tetrafluoroethylene-based polymer.
[9] The cathode electrode of any one of [1] to [3], wherein the metal ion comprises an alkali metal ion and/or an alkaline earth metal ion.
[10] The cathode electrode of any one of [1] to [3], wherein the cation exchange substance substituted with a metal ion is formed as a layer on the copper.
[11] The cathode electrode of any one of [1] to [3], wherein the cation exchange substance substituted with a metal ion is mixed with the copper.
[12] The cathode electrode of any one of [1] to [3], comprising a porous structure.
[13] A composite body, comprising: a base material; and the cathode electrode of any one of [1] to [3] arranged on the base material.
[14] The composite body of [13], wherein the base material comprises a porous structure.
[15] The composite body of [14], wherein a material of the base material comprising a porous structure is carbon, fluorine-containing resin, or metal.
[16] The composite body of [14], wherein: a material of the base material comprising a porous structure is metal; and the metal is copper.
[17] The composite body of [14], wherein: a material of the base material comprising a porous structure is metal; and the metal is a sintered body of copper particles.
[18] An electrolytic reduction device for electrically reducing carbon dioxide to carbon monoxide, olefinic hydrocarbons, and/or alcohols, the electrolytic reduction device comprising the cathode electrode of any one of [1] to [3].
[19] An electrolytic reduction device for electrically reducing carbon dioxide to carbon monoxide, olefinic hydrocarbons, and/or alcohols, the electrolytic reduction device comprising the composite body of [13].
[20] A method for producing a composite body of a cathode electrode and a base material for electrically reducing carbon dioxide, comprising: a step of preparing a base material having a porous structure; a sputtering layer formation step of forming a sputtering layer containing copper on the base material by sputtering; and a metal-ion-substituted cation exchange substance application step of applying a cation exchange substance substituted with a metal ion onto the sputtering layer to surface-modify the copper.
[21] The method for producing a composite body of [20], wherein the copper comprises: divalent copper; and zero-valent copper and/or monovalent copper.
[22] The method for producing a composite body of [20], wherein the copper comprises: monovalent copper and/or divalent copper for reduction, which is reduced to zero-valent copper by a reduction treatment; and monovalent copper and/or divalent copper, which is not reduced to zero-valent copper.
[23] The method for producing a composite body of any one of [20] to [22], wherein the sputtering layer further comprises at least one additive element selected from a group consisting of silver, gold, cadmium, tin, aluminum, boron, gallium, zinc, titanium, and silicon.
[24] The method for producing a composite body of [21] or [22], further comprising a copper oxidation treatment step of oxidizing at least a part of the copper in the sputtering layer to monovalent copper and/or divalent copper, after the sputtering layer formation step and before the metal-ion-substituted cation exchange substance application step.
[25] The method for producing a composite body of [24], further comprising a partial reduction step of partially reducing the monovalent copper and/or the divalent copper oxidized in the copper oxidation treatment step to zero-valent copper and/or monovalent copper before the metal-ion-substituted cation exchange substance application step.
[26] The method for producing a composite body of [24], wherein the copper oxidation treatment step is electroless plating.
[27] The method for producing a composite body of [23], wherein the sputtering layer formation step comprises: a copper sputtering layer formation step of forming a copper sputtering layer, which is a sputtering layer containing copper; and an additive element sputtering layer formation step of forming an additive element sputtering layer, which is a sputtering layer containing the additive element.
[28] The method for producing a composite body of [27], wherein the sputtering layer formation step comprises a copper sputtering layer formation step of further forming a copper sputtering layer which is a sputtering layer containing copper.

### Advantageous Effects of Invention

According to an aspect of the cathode electrode of the present invention, because it comprises copper and the copper is surface-modified with a cation exchange substance substituted with a metal ion, the supply of water molecules (H₂O) to the copper constituting the cathode electrode is controlled by the cation exchange substance substituted with a metal ion. This reduces the selectivity of hydrogen, which is a side-reaction product, and allows the catalytic reaction for producing olefinic hydrocarbons such as ethylene and alcohols such as ethanol through the carbon dioxide reduction reaction to be stably sustained with high efficiency over a long period. The cation exchange substance substituted with a metal ion has a structure in which the hydrogen ions (H⁺) of the cation exchange substance are substituted with metal ions, and therefore has a structure with a reduced content of hydrogen ions (H⁺).

In the carbon dioxide reduction reaction at a cathode electrode in which copper is used as a catalyst material, it is considered that the boundary between copper of different valences present in the cathode electrode (e.g., the boundary between zero-valent copper and monovalent copper) mainly functions as a site in which C-C bonds are formed from carbon dioxide-derived carbons and in which the C-C bonds are stabilized. That is, it is considered that the boundary between copper of different valences (e.g., the boundary between zero-valent copper and monovalent copper) is the main active site for the carbon dioxide reduction reaction. From the above, according to an aspect of the cathode electrode of the present invention, by the copper comprising divalent copper and zero-valent copper and/or monovalent copper, or by the copper comprising monovalent copper and/or divalent copper for reduction, which is reduced to zero-valent copper by a reduction treatment, and monovalent copper and/or divalent copper, which is not reduced to zero-valent copper, it is possible to more reliably sustain the catalytic reaction for producing olefinic hydrocarbons such as ethylene and alcohols such as ethanol through the carbon dioxide reduction reaction with high efficiency over a long period.

In a cathode electrode in which copper is used as a catalyst material, during the carbon dioxide reduction reaction, monovalent copper is reduced to zero-valent copper, and divalent copper is reduced to zero-valent or monovalent copper. When the carbon dioxide reduction reaction is sustained for a long period, it is considered that divalent copper is reduced to zero-valent or monovalent copper, and monovalent copper is reduced to zero-valent copper, leading to a tendency for the boundary between copper of different valences (e.g., the boundary between zero-valent copper and monovalent copper) to decrease. From the above, according to an aspect of the cathode electrode of the present invention, by comprising, in addition to copper, at least one additive element selected from the group consisting of silver, gold, cadmium, tin, aluminum, boron, gallium, zinc, titanium, and silicon, the additive element has the function of retaining oxygen within the cathode electrode, thereby appropriately suppressing the reduction of monovalent copper to zero-valent copper. From the above, even when the carbon dioxide reduction reaction is sustained for a long period, the abundance ratio of zero-valent copper to monovalent copper is reliably optimized, thereby maintaining the formation and stabilization of C-C bonds, and more reliably sustaining the catalytic reaction for producing olefinic hydrocarbons such as ethylene and alcohols such as ethanol through the carbon dioxide reduction reaction with high efficiency over a long period.

It should be noted that both ethylene and ethanol are C2 compounds, and the formation of C-C bonds on the catalyst material is an intermediate step in the reaction pathways. Therefore, since the active sites for ethylene production and ethanol production are identical or very close, the stability of ethylene production and the stability of ethanol production show similar trends, and the carbon dioxide reduction reaction proceeds in the same manner for ethylene production and ethanol production.

According to an aspect of the cathode electrode of the present invention, by comprising 0.10 atomic% or more and 1.0 atomic% or less of the additive element with respect to 100 atomic% of the copper, the abundance ratio of zero-valent copper to monovalent copper is reliably optimized even when the carbon dioxide reduction reaction is sustained for a long period, and the catalytic reaction for producing olefinic hydrocarbons such as ethylene and alcohols such as ethanol through the carbon dioxide reduction reaction can be more stably sustained.

According to an aspect of the cathode electrode of the present invention, by comprising 0.25 atomic% or more and 0.70 atomic% or less of the additive element with respect to 100 atomic% of the copper, the abundance ratio of zero-valent copper to monovalent copper can be maintained in a more appropriate range even when the carbon dioxide reduction reaction is sustained for a long period, and the catalytic reaction for producing olefinic hydrocarbons such as ethylene and alcohols such as ethanol through the carbon dioxide reduction reaction can be sustained more stably over a longer period.

According to an aspect of the cathode electrode of the present invention, by the additive element comprising aluminum, the function of appropriately retaining oxygen within the cathode electrode is reliably obtained. Therefore, the abundance ratio of zero-valent copper to monovalent copper is reliably optimized even when the carbon dioxide reduction reaction is sustained for a long period, and the catalytic reaction for producing olefinic hydrocarbons such as ethylene and alcohols such as ethanol through the carbon dioxide reduction reaction can be more stably sustained.

According to an aspect of the cathode electrode of the present invention, by the cation exchange substance comprising a sulfonated tetrafluoroethylene-based polymer and the metal ions comprising an alkali metal ion and/or an alkaline earth metal ion, the supply of water molecules (H₂O) to the copper constituting the cathode electrode is reliably controlled. This more reliably reduces the selectivity of hydrogen, which is a side-reaction product, and more reliably allows the catalytic reaction for producing olefinic hydrocarbons such as ethylene and alcohols such as ethanol through the carbon dioxide reduction reaction to be stably sustained with high efficiency over a long period.

According to an aspect of the cathode electrode of the present invention, by the cation exchange substance substituted with a metal ion being formed as a layer on the copper, or by the cation exchange substance substituted with a metal ion being mixed with the copper, the supply of water molecules (H₂O) to the copper is more appropriately controlled by the presence of the cation exchange substance substituted with a metal ion.

According to an aspect of the cathode electrode of the present invention, by the cathode electrode comprising a porous structure, the contact between water and carbon dioxide is facilitated at the site of the carbon dioxide reduction reaction of the cathode electrode, so that the catalytic reaction for producing olefinic hydrocarbons such as ethylene and alcohols such as ethanol can be more stably sustained over a long period.

According to an aspect of the composite body of the cathode electrode and a base material of the present invention, by comprising a base material and the cathode electrode of the present invention, it is possible to obtain a composite body of the cathode electrode and a base material in which the selectivity of hydrogen which is a side-reaction product is reduced, and the catalytic reaction for producing olefinic hydrocarbons such as ethylene and alcohols such as ethanol through the carbon dioxide reduction reaction can be stably sustained with high efficiency over a long period.

According to an aspect of the composite body of the cathode electrode and a base material of the present invention, by the base material comprising a porous structure, gaseous carbon dioxide can smoothly contact the cathode electrode, so that the catalytic reaction for producing olefinic hydrocarbons such as ethylene and alcohols such as ethanol can be more stably sustained over a long period, even with gas-phase carbon dioxide.

According to the method for producing the composite body of the cathode electrode and a base material of the present invention, by comprising a sputtering layer formation step of forming a sputtering layer containing copper on the base material by sputtering, and a metal-ion-substituted cation exchange substance application step of applying a cation exchange substance substituted with a metal ion onto the sputtering layer to surface-modify the copper, it is possible to produce a composite body in which the selectivity of hydrogen which is a side-reaction product is reduced, and the catalytic reaction for producing olefinic hydrocarbons such as ethylene and alcohols such as ethanol through the carbon dioxide reduction reaction can be stably sustained with high efficiency over a long period.

### Brief Description of Drawings

Fig. 1 is an explanatory diagram showing an outline of a cross-section of the composite body of the cathode electrode and the base material of the present invention.
Fig. 2 is an explanatory diagram of the electropolishing treatment step in the method for producing the composite body of the cathode electrode and the base material.
Fig. 3 is an explanatory diagram of the sputtering layer formation step and the copper oxidation treatment step in the method for producing the composite body of the cathode electrode and the base material.
Fig. 4 is an explanatory diagram of the partial reduction step in the method for producing the composite body of the cathode electrode and the base material.
Fig. 5 is an explanatory diagram showing the structure of the composite body of the cathode electrode and the base material of the present invention.
Fig. 6 is an explanatory diagram showing an outline of the electrolytic reduction device provided with the cathode electrode of the present invention.
Fig. 7 is an explanatory diagram showing an outline of another electrolytic reduction device provided with the cathode electrode of the present invention.

### Description of Embodiments

### [Cathode Electrode]

The cathode electrode of the present invention is described below. The cathode electrode of the present invention is a cathode electrode which electrically reduces carbon dioxide, the cathode electrode containing copper (Cu), in which the copper (Cu) is surface-modified with a cation exchange substance substituted with a metal ion. The cathode electrode of the present invention contains copper, which is a catalyst material, and a cation exchange substance substituted with a metal ion, which modifies the surface of the copper as essential components. The cation exchange substance substituted with a metal ion has a chemical structure in which the hydrogen ions (H⁺) of the cation exchange substance are substituted with metal ions, and is a cation exchange substance with a reduced content of hydrogen ions (H⁺)

Due to the presence of the cation exchange substance substituted with a metal ion (a cation exchange substance in which the hydrogen ions (H⁺) are substituted with metal ions) on the surface of the copper which is the catalyst material constituting the cathode electrode, the supply amount of water molecules (H₂O), i.e., the supply amount of hydrogen ions (H⁺), to the copper is controlled. Further, since the cation exchange substance is substituted with metal ions and the content of hydrogen ion (H⁺) is reduced, the supply of hydrogen ions (H⁺) from the cation exchange substance to the copper is also prevented. Therefore, the cathode electrode of the present invention has a structure that can prevent an excessive supply of hydrogen ions (H⁺) to the copper catalyst material. It should be noted that, since the state in which hydrogen ions are substituted with metal ions is more stable than the state in which they are not in the cation exchange substance, the cation exchange substance is maintained in a metal-ion-substituted state in the cathode electrode.

From the above, the selectivity of hydrogen which is a side-reaction product of the carbon dioxide reduction reaction is reduced, and the catalytic reaction for producing olefinic hydrocarbons such as ethylene and alcohols such as ethanol through the carbon dioxide reduction reaction can be stably sustained with high efficiency over a long period.

Examples of the cation exchange substance constituting the cation exchange substance substituted with a metal ion, that is, the cation exchange substance before being substituted with a metal ion, include cation exchange resins. Examples of the cation exchange resin include sulfonated tetrafluoroethylene-based polymers (trade name "Nafion"), perfluoroalkyl substance (PFAS)-based polymers, and polyethylenedioxythiophene (PEDOT)-based polymers. Among these, sulfonated tetrafluoroethylene-based polymers are preferable from the viewpoint of easy modification of the copper surface.

The metal ions constituting the cation exchange substance substituted with a metal ion are not particularly limited as long as the hydrogen ion of the cation exchange substance is substituted with a metal ion. Alkali metal ions and alkaline earth metal ions are preferable from the viewpoint of reliably controlling the supply amount of water molecules (H₂O) to the copper constituting the cathode electrode, more reliably reducing the selectivity of hydrogen which is a side-reaction product, and more reliably sustaining the catalytic reaction for producing olefinic hydrocarbons such as ethylene and alcohols such as ethanol with high efficiency over a long period. Examples of the alkali metal include lithium ion (Li⁺), sodium ion (Na⁺), potassium ion (K⁺), rubidium ion (Rb⁺), cesium ion (Cs⁺), and francium ion (Fr⁺). Examples of the alkaline earth metal ion include beryllium ion (Be²⁺), magnesium ion (Mg²⁺), calcium ion (Ca²⁺), strontium ion (Sr²⁺), barium ion (Ba²⁺), and radium ion (Ra²⁺). These metal ions may be used alone or in combination of two or more.

Among these metal ions, alkali metal ions are more preferable, and lithium ion (Li⁺), sodium ion (Na⁺), potassium ion (K⁺), and rubidium ion (Rb⁺) are even more preferable from the viewpoint of more reliably controlling the supply amount of water molecules (H₂O) to the copper constituting the cathode electrode, and more reliably reducing the selectivity of hydrogen which is a side-reaction product. From the viewpoint of further controlling the supply amount of water molecules (H₂O) to the copper and further reducing the selectivity of hydrogen which is a side-reaction product, potassium ion (K⁺) is particularly preferable.

The aspect in which the copper is surface-modified with the cation exchange substance substituted with a metal ion is not particularly limited. The aspect in which the cation exchange substance substituted with a metal ion is formed as a layer on the copper, and the aspect in which the cation exchange substance substituted with a metal ion is mixed with the copper are preferable from the viewpoint that the supply amount of water molecules to the copper can be more appropriately controlled by the presence of the cation exchange substance substituted with a metal ion, and the aspect in which the cation exchange substance substituted with a metal ion is formed as a layer on the copper is particularly preferable.

The content of the cation exchange substance substituted with a metal ion is not particularly limited. Its lower limit is preferably such that the deposited amount of the cation exchange substance is 125 g or more and 24333 g or less per 100 g of copper element, from the viewpoint of reliably controlling the supply amount of water molecules to the copper to reliably prevent an excessive supply of hydrogen ions (H⁺) to the copper.

For example, a method for preparing the cation exchange substance substituted with a metal ion is as follows: a solution of the cation exchange substance (e.g., an aqueous solution) and a metal ion-containing solution (e.g., an aqueous solution) are prepared, and by mixing the cation exchange substance solution and the metal ion-containing solution, the hydrogen ions of the cation exchange substance are substituted with metal ions, whereby the cation exchange substance substituted with a metal ion can be obtained.

In the cathode electrode of the present invention, as a first aspect of the cathode electrode, copper as a catalyst material comprises divalent copper, and zero-valent copper and/or monovalent copper. In the first aspect of the cathode electrode, divalent copper, and zero-valent copper and/or monovalent copper are comprised as essential components. Examples of the monovalent copper include cuprous oxide (Cu₂O), and examples of the divalent copper include cupric oxide (CuO). Examples of the zero-valent copper include a simple substance of copper (Cu).

In the carbon dioxide reduction reaction at a cathode electrode in which copper is used as a catalyst material, it is considered that the boundary between copper of different valences (e.g., the boundary between zero-valent copper and monovalent copper) mainly functions as a site in which C-C bonds are formed from carbon dioxide-derived carbons and in which the C-C bonds are stabilized, that is, the boundary between copper of different valences (e.g., the boundary between zero-valent copper and monovalent copper) is the main active site for the carbon dioxide reduction reaction. From the above, by the copper as a catalyst material comprising divalent copper and zero-valent copper and/or monovalent copper, the catalytic reaction for producing olefinic hydrocarbons such as ethylene and alcohols such as ethanol through the carbon dioxide reduction reaction can be more reliably sustained with high efficiency over a long period.

In the cathode electrode of the present invention, as a second aspect of the cathode electrode, the copper comprises monovalent copper and/or divalent copper for reduction which is reduced to zero-valent copper by a reduction treatment, and monovalent copper and/or divalent copper which is not reduced to zero-valent copper. In the second aspect of the cathode electrode, a part of the monovalent copper and/or divalent copper is reduced to become zero-valent copper. From the above, in the second aspect of the cathode electrode, as copper (Cu), there exist monovalent copper and/or divalent copper for reduction, and monovalent copper and/or divalent copper which is not reduced to zero-valent copper. The second aspect of the cathode electrode described above comprises monovalent copper and/or divalent copper as essential components. In the second aspect of the cathode electrode, by being subjected to a reduction treatment, divalent copper for reduction is reduced to zero-valent copper or monovalent copper, and monovalent copper for reduction is reduced to zero-valent copper. Therefore, in the second aspect of the cathode electrode, the reduction treatment results in a cathode electrode containing zero-valent copper and monovalent copper and/or divalent copper.

Examples of the monovalent copper include cuprous oxide (Cu₂O), and examples of the divalent copper include cupric oxide (CuO). Further, examples of the zero-valent copper include a simple substance of copper (Cu).

By the copper as a catalyst material comprising monovalent copper and/or divalent copper for reduction which is reduced to zero-valent copper by a reduction treatment, and monovalent copper and/or divalent copper which is not reduced to zero-valent copper, the catalytic reaction for producing olefinic hydrocarbons such as ethylene and alcohols such as ethanol through the carbon dioxide reduction reaction can be more reliably sustained with high efficiency over a long period.

In the cathode electrode of the present invention (including the first and second aspects of the cathode electrode), the catalyst material may further comprise, in addition to copper (Cu), at least one additive element (M) selected from the group consisting of silver (Ag), gold (Au), cadmium (Cd), tin (Sn), aluminum (Al), boron (B), gallium (Ga), zinc (Zn), titanium (Ti), and silicon (Si) as an optional component.

In the cathode electrode of the present invention, copper is used as a catalyst material, and during the carbon dioxide reduction reaction, monovalent copper is reduced to zero-valent copper, and divalent copper is reduced to zero-valent or monovalent copper. Therefore, when the carbon dioxide reduction reaction is sustained for a long period, it is considered that divalent copper is reduced to zero-valent or monovalent copper, and monovalent copper is reduced to zero-valent copper, leading to a tendency for the boundary between copper of different valences (e.g., the boundary between zero-valent copper and monovalent copper) to decrease. Therefore, by comprising, in addition to copper, at least one additive element (M) selected from the group consisting of silver, gold, cadmium, tin, aluminum, boron, gallium, zinc, titanium, and silicon, the additive element (M) has the function of retaining oxygen within the cathode electrode, thereby appropriately suppressing the reduction of monovalent copper to zero-valent copper. From the above, even when the carbon dioxide reduction reaction is sustained for a long period, the abundance ratio of zero-valent copper to monovalent copper is reliably optimized, thereby maintaining the formation and stabilization of C-C bonds, and more reliably sustaining the catalytic reaction for producing olefinic hydrocarbons such as ethylene and alcohols such as ethanol through the carbon dioxide reduction reaction with high efficiency over a long period.

The aspect of at least one additive element (M) selected from the group consisting of silver, gold, cadmium, tin, aluminum, boron, gallium, zinc, titanium, and silicon is not particularly limited, and examples thereof include the additive element (M) itself (simple substance of the additive element (M)). In addition to the aspect of the additive element (M) itself, the aspects of hydroxides and oxides can be mentioned. The aspect of the additive element (M) may also be a mixture of the aspect of the additive element (M) itself, the aspect of hydroxide, and the aspect of oxide. These additive elements (M) may be used alone or in combination of two or more.

The content of the additive element (M) is not particularly limited. Its lower limit is preferably 0.10 atomic%, and more preferably 0.20 atomic% with respect to 100 atomic% of the total copper element including zero-valent copper, monovalent copper, divalent copper and the like. This is because even when the carbon dioxide reduction reaction is sustained for a long period, the abundance ratio of zero-valent copper to monovalent copper is reliably optimized, and the catalytic reaction for producing olefinic hydrocarbons such as ethylene and alcohols such as ethanol through the carbon dioxide reduction reaction can be more stably sustained. The lower limit is particularly preferably 0.25 atomic% because even when the carbon dioxide reduction reaction is sustained for a long period, the abundance ratio of zero-valent copper to monovalent copper can be maintained within a more appropriate range, and the catalytic reaction for producing olefinic hydrocarbons such as ethylene and alcohols such as ethanol through the carbon dioxide reduction reaction can be even more stably sustained for a longer period. On the other hand, the upper limit of the content of the additive element (M) is preferably 1.0 atomic%, and more preferably 0.85 atomic% with respect to 100 atomic% of the total copper element including zero-valent copper, monovalent copper, divalent copper and the like. This is because even when the carbon dioxide reduction reaction is sustained for a long period, the abundance ratio of zero-valent copper to monovalent copper is reliably optimized, and the catalytic reaction for producing olefinic hydrocarbons such as ethylene and alcohols such as ethanol through the carbon dioxide reduction reaction can be more stably sustained for a long period. The upper limit is particularly preferably 0.70 atomic% because even when the carbon dioxide reduction reaction is sustained for a long period, the abundance ratio of zero-valent copper to monovalent copper can be maintained within a more appropriate range, and the catalytic reaction for producing olefinic hydrocarbons such as ethylene and alcohols such as ethanol through the carbon dioxide reduction reaction can be even more stably sustained for a longer period.

As the additive element (M), any of silver, gold, cadmium, tin, aluminum, boron, gallium, zinc, titanium, and silicon can be used, as they tend to be more easily oxidized and have a higher affinity for oxygen compared to copper. On the other hand, among these additive elements (M), aluminum is preferable from the viewpoint that the function of appropriately retaining oxygen within the cathode electrode is reliably obtained, so that the abundance ratio of zero-valent copper to monovalent copper is reliably optimized even when the carbon dioxide reduction reaction is sustained for a long period, and the catalytic reaction for producing olefinic hydrocarbons such as ethylene and alcohols such as ethanol through the carbon dioxide reduction reaction can be more stably sustained.

The structure of the cathode electrode is not particularly limited and may be solid or porous, and a porous structure is preferable from the viewpoint that the contact between water and carbon dioxide is facilitated at the site of the carbon dioxide reduction reaction of the cathode electrode, thereby allowing the catalytic reaction for producing olefinic hydrocarbons such as ethylene and alcohols such as ethanol to be more stably sustained over a long period. The proportion of voids (porosity) in the porous structure is not particularly limited, and its lower limit is preferably 1 vol%, and particularly preferably 10 vol%, from the viewpoint that the penetration of carbon dioxide into the cathode electrode is facilitated, thereby further improving the production efficiency of olefinic hydrocarbons such as ethylene and alcohols such as ethanol. On the other hand, the upper limit of the porosity of the porous structure is preferably 99 vol%, and particularly preferably 90 vol%, from the viewpoint of maintaining the surface area contributing to the catalytic reaction of the cathode electrode, thereby further improving the production efficiency of olefinic hydrocarbons such as ethylene and alcohols such as ethanol.

The cathode electrode of the present invention can produce olefinic hydrocarbons such as ethylene and alcohols such as ethanol, for example, by supplying gaseous (gas-phase) carbon dioxide from one side of the cathode electrode and liquid-phase water from the other side, causing the gaseous (gas-phase) carbon dioxide and water to react through the catalytic action of the cathode electrode to electrically reduce the carbon dioxide.

### [Composite Body of Cathode Electrode and Base Material]

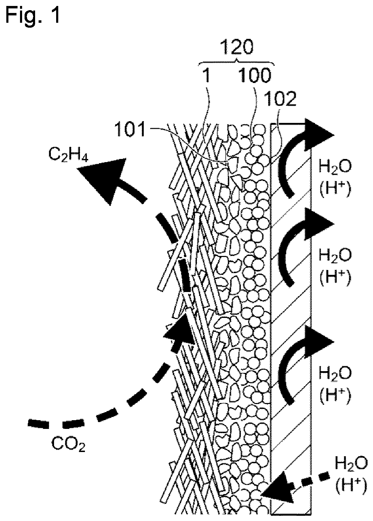

The cathode electrode of the present invention may be used as the cathode electrode alone, or it may be used in a state in which a composite body of the cathode electrode and a base material is formed, as described below. Fig. 1 is an explanatory diagram showing an outline of the cross-section of the composite body of the cathode electrode and the base material of the present invention.

As shown in Fig. 1, a composite body 120 of a cathode electrode 100 and a base material 1 has the base material 1 and the cathode electrode 100 of the present invention arranged on the base material 1. The cathode electrode 100 has a first portion 101 and a second portion 102 opposite the first portion 101. The base material 1 is provided on the side of the first portion 101 of the cathode electrode 100. That is, the side of the first portion 101 of the cathode electrode 100 is arranged on the base material 1. No base material is provided on the side of the second portion 102 of the cathode electrode 100, and the second portion 102 is exposed to the external environment of the cathode electrode 100 and the composite body 120. The cathode electrode 100 is a coating film that covers the surface of the base material 1. In the composite body 120 of the cathode electrode 100 and the base material 1, by being provided with the cathode electrode 100 of the present invention in which copper is surface-modified with a cation exchange substance substituted with a metal ion, the selectivity of hydrogen which is a side-reaction product is reduced, and the catalytic reaction for producing olefinic hydrocarbons such as ethylene and alcohols such as ethanol through the carbon dioxide reduction reaction can be stably sustained with high efficiency over a long period.

The structure of the cathode electrode 100 formed on the base material 1 may be solid or porous. As described above, a porous structure is preferable from the viewpoint that the contact between water and carbon dioxide is facilitated at the site of the carbon dioxide reduction reaction of the cathode electrode 100, thereby allowing the catalytic reaction for producing olefinic hydrocarbons such as ethylene and alcohols such as ethanol to be more stably sustained over a long period. The porous structure of the cathode electrode 100 can be formed, for example, by performing a partial reduction treatment described later. It should be noted that in Fig. 1, for convenience of explanation, the cathode electrode 100 is not represented as a porous structure.

The base material 1 may be solid or porous. A porous structure with gas permeability is preferable from the viewpoint that gaseous carbon dioxide can smoothly contact the cathode electrode, thereby allowing the catalytic reaction for producing olefinic hydrocarbons such as ethylene and alcohols such as ethanol to be more stably sustained over a long period, even with gas-phase carbon dioxide.

The material of the base material 1 with a porous structure is not particularly limited. For example, carbon, fluorine-containing resins, and metals are preferable from the viewpoint of being able to obtain the composite body of the cathode electrode and the base material in which the catalytic reaction for producing olefinic hydrocarbons such as ethylene and alcohols such as ethanol through the carbon dioxide reduction reaction can be more stably sustained over a long period. Examples of carbon include composite bodies of carbon black and carbon fibers. Examples of fluorine-containing resins include polytetrafluoroethylene, polyvinylidene fluoride, perfluoroalkoxy alkane, perfluoroethylene propylene copolymer, ethylene tetrafluoroethylene copolymer, polychlorotrifluoroethylene, and ethylene chlorotrifluoroethylene copolymer. Examples of metals include porous metals made of copper (Cu), niobium (Nb), aluminum (Al), titanium (Ti), alloys containing one or more kinds of the above metals, stainless steel and the like. When the material of the base material 1 with a porous structure is a metal and the metal is copper (Cu), examples of the porous metal include a sintered body of copper particles.

The average thickness of the base material 1 is not particularly limited. For example, a plate material with a thickness of 0.2 mm or more and 1.5 mm or less can be mentioned.

The cathode electrode 100 in the composite body 120 of the cathode electrode 100 and the base material 1 is, for example, a sputtering layer formed on the base material 1 by sputtering, which has copper and, if necessary, the additive element (M). It should be noted that the cathode electrode 100 in the composite body 120 of the cathode electrode 100 and the base material 1 may also be a co-electrodeposited layer formed by immersing the base material 1 in a co-electrodeposition solution containing copper ions and, if necessary, ions of the additive element (M), and co-electrodepositing the copper component and, if necessary, the additive element (M) onto the base material 1.

### [Method for Producing Composite Body of Cathode Electrode and Base Material]

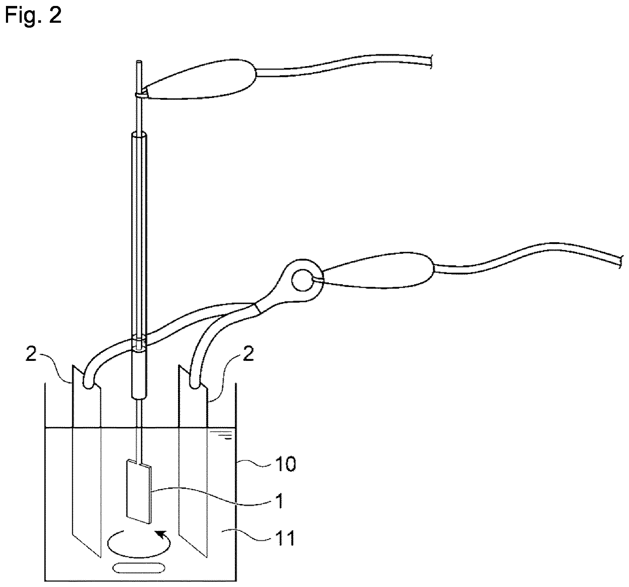

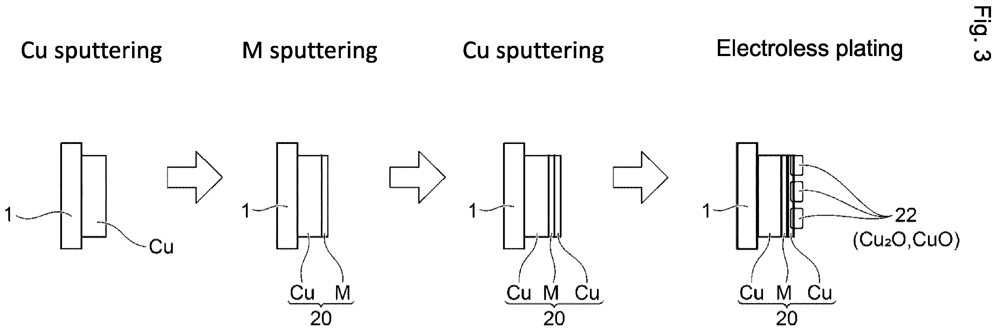

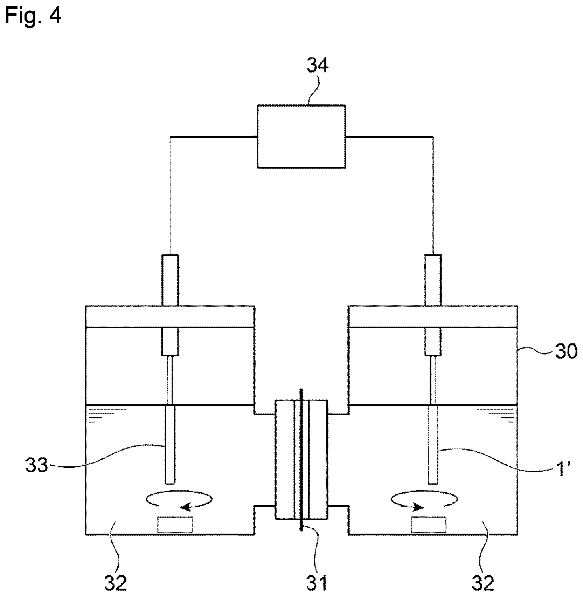

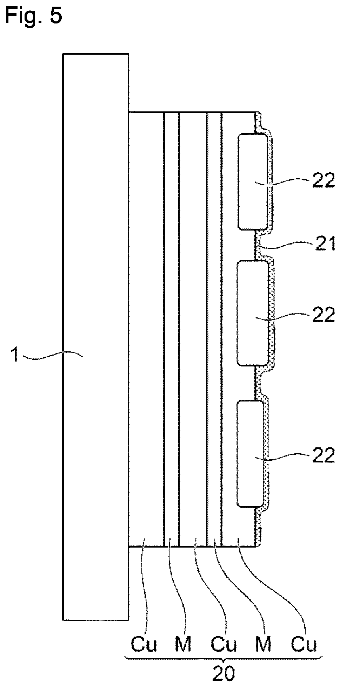

An example of a method for producing the composite body of the cathode electrode and the base material will be described below. Fig. 2 is an explanatory diagram of the electropolishing treatment step in the method for producing the composite body of the cathode electrode and the base material. Fig. 3 is an explanatory diagram of the sputtering layer formation step and the copper oxidation treatment step in the method for producing the composite body of the cathode electrode and the base material. Fig. 4 is an explanatory diagram of the partial reduction step in the method for producing the composite body of the cathode electrode and the base material. Fig. 5 is an explanatory diagram showing the structure of the composite body of the cathode electrode and the base material of the present invention.

The method for producing the composite body of the cathode electrode and the base material for electrically reducing carbon dioxide comprises: (1) a step of preparing a base material (e.g., a base material having a porous structure), (2) an electropolishing treatment step of performing an electropolishing treatment on the prepared base material as necessary, (3) a sputtering layer formation step of forming a sputtering layer containing copper on the base material, which has been subjected to the electropolishing treatment as necessary by sputtering, (4) a copper oxidation treatment step of oxidizing at least a part of the copper in the sputtering layer to monovalent copper and/or divalent copper as necessary after the sputtering layer formation step, (5) a partial reduction step of partially reducing the monovalent copper and/or divalent copper oxidized in the copper oxidation treatment step to zero-valent copper and/or monovalent copper as necessary, and (6) a metal-ion-substituted cation exchange substance application step of applying a cation exchange substance substituted with a metal ion onto the sputtering layer, which has undergone the copper oxidation treatment step and the partial reduction step as necessary, to surface-modify the copper of the sputtering layer. Among the above steps, steps (1), (3), and (6) are essential, and steps (2), (4), and (5) are optional.

By the method for producing the composite body of the cathode electrode and the base material described above, the cathode electrode in which copper as a catalyst material is surface-modified with a cation exchange substance substituted with a metal ion can be formed on the base material. By the method for producing the composite body of the cathode electrode and the base material described above, it is possible to produce the composite body in which the selectivity of hydrogen which is a side-reaction product is reduced, and the catalytic reaction for producing olefinic hydrocarbons such as ethylene and alcohols such as ethanol through the carbon dioxide reduction reaction can be stably sustained with high efficiency over a long period. Examples of the cathode electrode formed by the method for producing the composite body of the cathode electrode and the base material described above include cathode electrodes in which copper comprises divalent copper, and zero-valent copper and/or monovalent copper, and cathode electrodes in which copper comprises monovalent copper and/or divalent copper for reduction which is reduced to zero-valent copper by the reduction treatment, and monovalent copper and/or divalent copper which is not reduced to zero-valent copper.

### (1) Step of Preparing Base Material (e.g., a base material having a porous structure)

The step of preparing a base material (e.g., a base material having a porous structure) is a step of preparing the base material described above. The material of the base material and the porosity of the porous structure can be appropriately selected according to the characteristics required for the composite body of the cathode electrode and the base material.

### (2) Electropolishing Treatment Step

The electropolishing treatment step is a step performed as necessary, for example, when a metal is used as the material for the base material. In the electropolishing treatment step, after degreasing the surface of the base material with an organic solvent such as hexane, washing and drying it, as shown in Fig. 2, a mixed acid solution 11 is placed in a container 10, the base material 1 which is the anode is immersed in the mixed acid solution 11, a cathode 2 is immersed at a position sandwiching the base material 1, and an electrolytic potential is applied to the base material 1, which is the anode, and the cathode 2. By applying an electrolytic potential to the base material 1, which is the anode, and the cathode 2, the surface of the base material 1 is electropolished. By electropolishing the surface of the base material 1, the affected layer on the surface of the base material 1 is reduced or removed. As the mixed acid solution 11, for example, a mixed aqueous solution of phosphoric acid and sulfuric acid can be mentioned. As the cathode 2, for example, titanium and the like can be mentioned.

### (3) Sputtering Layer Formation Step

As shown in Fig. 3, in the sputtering layer formation step, a sputtering layer 20 containing copper is formed on the base material layer 1 by sputtering. When the sputtering layer 20 contains, in addition to copper (Cu), at least one additive element (M) selected from the group consisting of silver, gold, cadmium, tin, aluminum, boron, gallium, zinc, titanium, and silicon as an optional component, as shown in Fig. 3, the sputtering layer formation step comprises a copper (Cu) sputtering layer formation step of forming a sputtering layer of copper (Cu), which is a sputtering layer containing copper (Cu), on the base material 1 by sputtering, and an additive element (M) sputtering layer formation step of forming a sputtering layer of the additive element (M), which is a sputtering layer containing the additive element (M), on the copper (Cu) sputtering layer by sputtering. Furthermore, it comprises a copper (Cu) sputtering layer formation step of further forming a sputtering layer of copper (Cu), which is a sputtering layer containing copper (Cu), on the formed additive element (M) sputtering layer by sputtering. By adjusting the amount of power from the power source and the sputtering time, the content of the additive element (M) with respect to 100 atomic% of copper (Cu) can be adjusted. Further, if necessary, to make the presence of copper (Cu) and the additive element (M) uniform throughout the sputtering layer 20, the copper (Cu) sputtering layer formation step and the additive element (M) sputtering layer formation step may be performed alternately multiple times. Through the sputtering layer formation step, the cathode electrode containing divalent copper and zero-valent and/or monovalent copper, and optionally an additive element, or a cathode electrode containing monovalent and/or divalent copper for reduction which is reduced to zero-valent copper by a reduction treatment, and monovalent and/or divalent copper which is not reduced to zero-valent copper, and optionally an additive element, can be formed on the base material 1.

### (4) Copper Oxidation Treatment Step

The copper oxidation treatment step is performed as necessary when adjusting the abundance ratio of monovalent copper and/or divalent copper to a predetermined amount. As shown in Fig. 3, in the copper oxidation treatment step, an oxidation treatment by electroless plating is performed on the formed sputtering layer 20 to oxidize at least a part of the zero-valent copper (Cu) contained in the sputtering layer 20 into monovalent copper (Cu₂O) and/or divalent copper (CuO), thereby forming an oxidized portion 22. As the oxidation treatment by electroless plating, for example, an oxidation treatment method of immersing the sputtering layer 20 in a copper sulfate aqueous solution can be mentioned.

### (5) Partial Reduction Step

The partial reduction step is a step performed as necessary to further optimize the abundance ratio of zero-valent copper to monovalent copper by reducing the monovalent copper and/or divalent copper oxidized in the copper oxidation treatment step to zero-valent copper and/or monovalent copper. In the partial reduction step, as shown in Fig. 4, a composite body 1' obtained by forming the sputtering layer 20 on the base material 1, and an anode electrode 33 are immersed in a partial reduction aqueous solution 32 housed in a two-chamber electrolytic cell 30 having a diaphragm 31, and a partial reduction treatment is performed by applying an electrolytic potential from a power source 34 to the two-chamber electrolytic cell 30. Further, by performing the partial reduction treatment, the sputtering layer 20 can be made porous. As the anode electrode 33, for example, platinum can be mentioned. As the partial reduction aqueous solution 32, for example, a potassium bicarbonate aqueous solution can be mentioned for both the side of the composite 1' and the side of the anode electrode.

### (6) Metal-Ion-Substituted Cation Exchange Substance Application Step

The metal-ion-substituted cation exchange substance application step is a step of, as shown in Fig. 5, applying a cation exchange substance substituted with a metal ion 21 onto the sputtering layer 20, which has undergone the copper oxidation treatment step and the partial reduction step as necessary, to modify the surface of the copper of the sputtering layer 20 with the cation exchange substance substituted with a metal ion 21. When the oxidized portion 22 is formed by the copper oxidation treatment step, the cation exchange substance substituted with a metal ion 21 is also applied to the oxidized portion 22. As a method for applying the cation exchange substance substituted with a metal ion 21 onto the sputtering layer 20, for example, a method for spraying a solution of the cation exchange substance substituted with a metal ion 21 can be mentioned. By applying the cation exchange substance substituted with a metal ion 21 onto the sputtering layer 20, at least a part of the monovalent copper (Cu₂O) is oxidized to divalent copper (CuO).

### [Electrolytic Device]

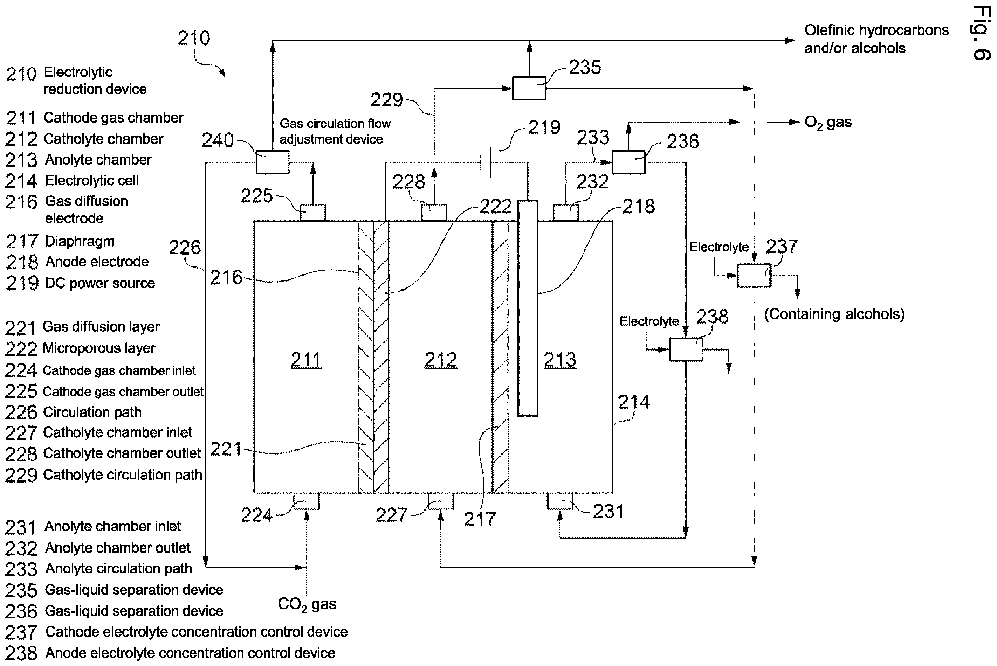

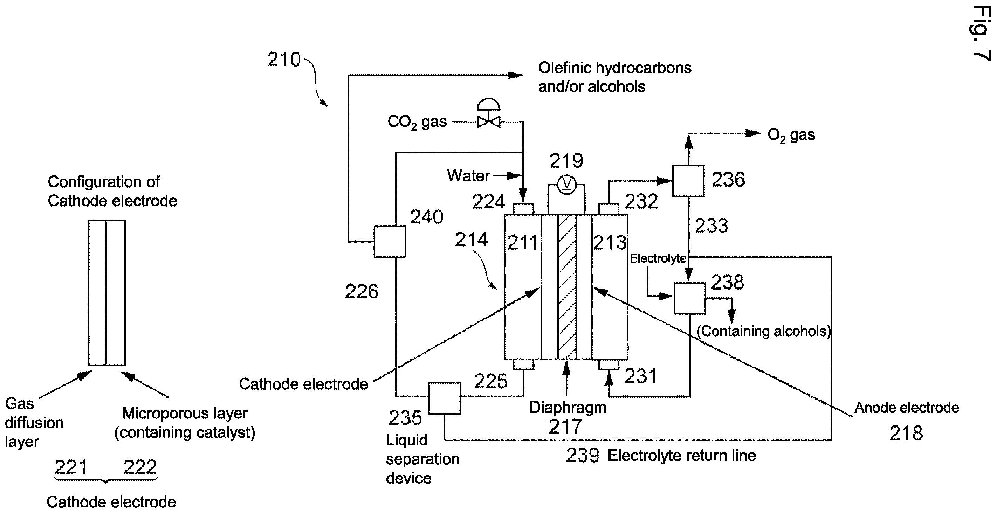

Next, an electrolytic reduction device provided with the cathode electrode of the present invention for electrically reducing carbon dioxide to carbon monoxide, olefinic hydrocarbons and/or alcohols, and an electrolytic reduction device provided with the composite body of the cathode electrode and a base material of the present invention for electrically reducing carbon dioxide to carbon monoxide, olefinic hydrocarbons and/or alcohols will be described. Fig. 6 is an explanatory diagram showing an outline of an electrolytic reduction device provided with the cathode electrode of the present invention. Fig. 7 is an explanatory diagram showing an outline of another electrolytic reduction device provided with the cathode electrode of the present invention.

Examples of the electrolytic reduction device 210 include a three-chamber electrolytic reduction device, as shown in Fig. 6. Specifically, the electrolytic reduction device 210 has, for example, an electrolytic cell 214 provided with a cathode gas chamber 211, a catholyte chamber 212, and an anolyte chamber 213, which are partitioned from each other. The cathode gas chamber 211 and the catholyte chamber 212 are partitioned by a cathode 216 serving as a gas diffusion electrode. The catholyte chamber 212 and the anolyte chamber 213 are partitioned by a diaphragm 217 having ion conductivity. An anode electrode 218 is arranged in the anolyte chamber 213. Gaseous carbon dioxide is supplied to the cathode gas chamber 211. A catholyte is supplied to the catholyte chamber 212. An anolyte is supplied to the anolyte chamber 213. The anode electrode 218 and the cathode 216 are connected to a DC power source 219.

The anolyte and the catholyte are aqueous solutions in which an electrolyte is dissolved. The electrolyte includes, for example, at least one of potassium, sodium, lithium, and a compound thereof. The electrolyte includes, for example, at least one compound selected from the group consisting of LiOH, NaOH, KOH, Li₂CO₃, Na₂CO₃, K₂CO₃, LiHCO₃, NaHCO₃, and KHCO₃.

The cathode 216 is a gas diffusion electrode and has a gas diffusion layer 221 and a microporous layer 222. In the electrolytic reduction device 210, the composite body of the cathode electrode of the present invention, in which the surface of copper is modified with a cation exchange substance substituted with a metal ion, and a base material is used as the cathode 216, and the microporous layer 222 corresponds to the base material of the composite body. The gas diffusion layer 221 allows gas containing carbon dioxide to permeate but suppresses the permeation of the aqueous solution containing the catholyte. The microporous layer 222 allows both the gas containing carbon dioxide and the aqueous solution containing the catholyte to permeate. The gas diffusion layer 221 and the microporous layer 222 are each formed in a planar shape. The gas diffusion layer 221 is arranged on the side of the cathode gas chamber 211, and the microporous layer 222 is arranged on the side of the catholyte chamber 212.

As the gas diffusion layer 221, for example, those in which a water-repellent film such as polytetrafluoroethylene is formed on the surface of a porous conductive base material such as carbon paper, carbon felt, and carbon cloth can be mentioned. The conductive base material is connected to the negative electrode of the DC power source 219 and receives a supply of electrons. The microporous layer 222 is formed on the surface of the gas diffusion layer 221 using carbon, fluorine-containing resin, metal, or the like, and supports a catalyst. In the electrolytic reduction device 210, the cathode electrode of the present invention, in which the surface of copper is modified with a cation exchange substance substituted with a metal ion, is used as the catalyst supported by the microporous layer 222. Further, by using renewable energy as the DC power source 219 of the electrolytic reduction device 210, it is possible to produce olefinic hydrocarbons such as ethylene and alcohols such as ethanol through the carbon dioxide reduction reaction while reducing the environmental load. It should be noted that, instead of the gas diffusion electrode having the gas diffusion layer 221 and the microporous layer 222, a gas diffusion electrode in which a part of the microporous layer 222 functions as the gas diffusion layer 221 may be provided.

Further, examples of another electrolytic reduction device 210 include an electrolytic reduction device 210 with an MEA type electrolytic cell structure, as shown in Fig. 7. In another electrolytic reduction device 210 shown in Fig. 7, the same components as in the electrolytic reduction device 210 shown in Fig. 6 are denoted by the same reference numerals. The electrolytic reduction device 210 with an MEA type electrolytic cell structure does not use a catholyte, and thus does not have a catholyte chamber 212. Therefore, the electrolytic reduction device 210 with an MEA type electrolytic cell structure has an electrolytic cell 214 provided with a cathode gas chamber 211 and an anolyte chamber 213, which are partitioned from each other, instead of an electrolytic cell 214 provided with a cathode gas chamber 211, a catholyte chamber 212, and an anolyte chamber 213, which are partitioned from each other. The cathode gas chamber 211 and the anolyte chamber 213 are partitioned by a diaphragm 217 sandwiched between the cathode electrode and the anode electrode 218. The anode electrode 218 is arranged in the anolyte chamber 213. Gaseous carbon dioxide is supplied to the cathode gas chamber 211. An anolyte is supplied to the anolyte chamber 213. The anode electrode 218 and the cathode electrode are connected to a DC power source 219. The electrolytic reduction device 210 with an MEA type electrolytic cell structure is suitable for integration because it does not use a catholyte, as the diaphragm 217 itself is used as the electrolyte.

In the electrolytic reduction device 210 with an MEA type electrolytic cell structure as well, the cathode electrode is a gas diffusion electrode and has a gas diffusion layer 221 and a microporous layer 222. Further, in the electrolytic reduction device 210 with an MEA type electrolytic cell structure, the composite body of the cathode electrode of the present invention, in which the surface of copper is modified with a cation exchange substance substituted with a metal ion, and a base material is also used as the cathode electrode, and the microporous layer 222 corresponds to the base material of the composite body.

### Examples

Hereinafter, examples of the present invention will be described. It should be noted that the present invention is not limited to the following examples.

### [Example 1]

### Preparation of Cathode Electrode

### Sputtering Layer Formation Step

On a base material (porous carbon), a copper layer was deposited by sputtering under the conditions of DC 100 W, argon gas 6.0 sccm, for 5 minutes, to form a first copper sputtering layer. Then, on the formed first copper sputtering layer, an aluminum layer was deposited by sputtering under the conditions of DC 50 W, argon gas 6.0 sccm, for 30 seconds, to form a first aluminum sputtering layer. Then, on the formed first aluminum sputtering layer, a copper layer was deposited by sputtering under the conditions of DC 100 W, argon gas 6.0 sccm, for 5 minutes, to form a second copper sputtering layer. Then, on the formed second copper sputtering layer, an aluminum layer was deposited by sputtering under the conditions of DC 50 W, argon gas 6.0 sccm, for 30 seconds, to form a second aluminum sputtering layer. Then, on the formed second aluminum sputtering layer, a copper layer was deposited by sputtering under the conditions of DC 100 W, argon gas 6.0 sccm, for 5 minutes, to form a third copper sputtering layer, resulting in a sputtering layer which is a laminated body of five layers.

### Copper Oxidation Treatment Step

The sputtering layer, which is a laminated body, obtained as described above was immersed in 100 mL of an aqueous solution containing copper sulfate and potassium sulfate (9.7 mM copper ion, 0.5 M sulfate ion) and subjected to electroless plating at 20°C for 20 minutes to oxidize a part of the zero-valent copper contained in the copper sputtering layers into monovalent copper and/or divalent copper.

### Metal-Ion-Substituted Cation Exchange Substance Application Step

An aqueous solution of a cation exchange resin (sulfonated tetrafluoroethylene-based polymer, "Nafion" (registered trademark), DuPont) (concentration: 5 mass%) and an aqueous solution of potassium hydroxide (concentration: 8 M) were mixed to prepare an aqueous solution of potassium-ion-substituted cation exchange resin (an aqueous solution of a cation exchange resin in which the hydrogen ions are substituted with potassium ions). The obtained aqueous solution of potassium-ion-substituted cation exchange resin was spray-coated (coating amount of the aqueous solution of potassium-ion-substituted cation exchange resin: 650 µL) onto the surface of the sputtering layer which is the five-layered laminated body and had undergone the copper oxidation treatment step, and then heat-dried. The surface of the copper of the sputtering layer was modified with the potassium-ion-substituted cation exchange resin such that the deposited amount of the cation exchange resin (Nafion) was 125 g to 24333 g per 100 g of copper element, based on the weight difference before and after coating.

As described above, a cathode electrode, which is a sputtering layer, was prepared on a base material, and a composite of the cathode electrode and the base material was produced.

### [Comparative Example 1]

A composite body of a cathode electrode and a base material was produced in the same manner as in Example 1, except that a potassium hydroxide application step described below was used instead of the metal-ion-substituted cation exchange substance application step. From the above, in Comparative Example 1, the copper of the sputtering layer, which is a five-layered laminated body, was not surface-modified with the potassium-ion-substituted cation exchange resin. Instead, it was surface-modified with potassium ions and hydroxide ions to form the composite body of the cathode electrode and the base material.

### Potassium Hydroxide Application Step

An aqueous potassium hydroxide solution was prepared by adding 500 µL of water to an 8 M aqueous potassium hydroxide solution, and the prepared aqueous potassium hydroxide solution was spray-coated (coating amount of aqueous potassium hydroxide solution: 600 µL) onto the surface of the sputtering layer, which was the five-layered laminated body and had been subjected to the copper oxidation treatment step, and then heat-dried to modify the surface of the copper of the sputtering layer with potassium ions and hydroxide ions.

### Evaluation Items

### [Stability Test]

The ethylene gas selectivity (E24, unit: %) was measured 24 hours after the start of the carbon dioxide reduction reaction. E24 of 50% or more was evaluated as excellent in catalytic reaction stability, indicating that the catalytic reaction for producing ethylene through the carbon dioxide reduction reaction can be stably sustained over a long period. The ethylene gas selectivity was evaluated as follows.

### [Ethylene Gas Selectivity (%)]

From the concentration of ethylene contained in the outlet gas of the electrolytic cell (electrolyte: 1 M KHCO₃ aqueous solution, electrolyte flow rate: 50 mL/min) and the gas flow rate, the number of moles of ethylene per unit time and the required number of moles of electrons were calculated (carbon dioxide gas flow rate: 40 mL/min). On the other hand, from the set current value (-530 mA) of the potential application device, the number of moles of electrons that passed through the electrolytic cell per unit time was calculated. The ratio of the former to the latter was evaluated as the ethylene selectivity (%). The concentration of ethylene contained in the outlet gas was measured using a gas chromatograph (model number: Agilent 990 Micro GC). The gas flow rate was measured using a mass flow meter.

The measurement results for Examples and Comparative Examples are shown in Table 1 below.

**[Table 1]**

| | Example 1 | Comparative Example 1 |
|---|---|---|
| E24 (unit:%) | 57 | 27 |

As shown in Table 1 above, in Example 1 in which the surface of the copper of the sputtering layer was modified with a potassium-ion-substituted cation exchange resin, the ethylene gas selectivity (E24) at 24 hours after the start of the carbon dioxide reduction reaction was 50% or more, and the catalytic reaction for producing ethylene through the carbon dioxide reduction reaction could be stably sustained over a long period, showing excellent stability of the catalytic reaction.

On the other hand, in Comparative Example 1 in which the surface of the copper of the sputtering layer was modified with potassium ions and hydroxide ions, the ethylene gas selectivity (E24) at 24 hours after the start of the carbon dioxide reduction reaction was 27%, and it could not be evaluated that the catalytic reaction for producing ethylene through the carbon dioxide reduction reaction could be stably sustained over a long period.

It should be noted that, when the cathode electrode of Example 1 and the cathode electrode of Comparative Example 1 were analyzed by X-ray diffraction (XRD) before and after the stability test, no significant difference was observed in the diffraction X-ray intensity peaks of zero-valent copper (Cu), monovalent copper (Cu₂O), and divalent copper (CuO) between Example 1 and Comparative Example 1, both before and after the stability test.

### Industrial Applicability

The cathode electrode of the present invention is highly valuable for industrial use in the field of absorbing and recovering atmospheric carbon dioxide to produce industrially useful organic compounds from carbon dioxide, as the catalytic reaction for producing olefinic hydrocarbons such as ethylene and alcohols such as ethanol through the carbon dioxide reduction reaction can be stably sustained over a long period.

### Reference Signs List

- 1: Base material
- 20: Sputtering layer
- 21: Cation exchange substance substituted with a metal ion
- 100: Cathode electrode
- 120: Composite body

## Claims

1. A cathode electrode which electrically reduces carbon dioxide, the cathode electrode comprising copper, wherein the copper is surface-modified with a cation exchange substance substituted with a metal ion.

2. The cathode electrode of Claim 1, wherein the copper comprises: divalent copper; and zero-valent copper and/or monovalent copper.

3. The cathode electrode of Claim 1, wherein the copper comprises: monovalent copper and/or divalent copper for reduction, which is reduced to zero-valent copper by a reduction treatment; and monovalent copper and/or divalent copper, which is not reduced to zero-valent copper.

4. The cathode electrode of any one of Claims 1 to 3, further comprising at least one additive element selected from a group consisting of silver, gold, cadmium, tin, aluminum, boron, gallium, zinc, titanium, and silicon.

5. The cathode electrode of Claim 4, wherein 0.10 atomic% or more and 1.0 atomic% or less of the additive element is comprised with respect to 100 atomic% of the copper.

6. The cathode electrode of any one of Claims 1 to 3, wherein the cation exchange substance comprises a sulfonated tetrafluoroethylene-based polymer.

7. The cathode electrode of any one of Claims 1 to 3, wherein the metal ion comprises an alkali metal ion and/or an alkaline earth metal ion.

8. The cathode electrode of any one of Claims 1 to 3, wherein the cation exchange substance substituted with a metal ion is formed as a layer on the copper.

9. The cathode electrode of any one of Claims 1 to 3, wherein the cation exchange substance substituted with a metal ion is mixed with the copper.

10. The cathode electrode of any one of Claims 1 to 3, comprising a porous structure.

11. A composite body, comprising: a base material; and the cathode electrode of any one of Claims 1 to 3 arranged on the base material.

12. An electrolytic reduction device for electrically reducing carbon dioxide to carbon monoxide, olefinic hydrocarbons, and/or alcohols, the electrolytic reduction device comprising the cathode electrode of any one of Claims 1 to 3.

13. An electrolytic reduction device for electrically reducing carbon dioxide to carbon monoxide, olefinic hydrocarbons, and/or alcohols, the electrolytic reduction device comprising the composite body of Claim 11.

14. A method for producing a composite body of a cathode electrode and a base material for electrically reducing carbon dioxide, comprising:
a step of preparing a base material having a porous structure;
a sputtering layer formation step of forming a sputtering layer containing copper on the base material by sputtering; and
a metal-ion-substituted cation exchange substance application step of applying a cation exchange substance substituted with a metal ion onto the sputtering layer to surface-modify the copper.

15. The method for producing a composite body of Claim 14, wherein the copper comprises: divalent copper; and zero-valent copper and/or monovalent copper.

16. The method for producing a composite body of Claim 14, wherein the copper comprises: monovalent copper and/or divalent copper for reduction, which is reduced to zero-valent copper by a reduction treatment; and monovalent copper and/or divalent copper, which is not reduced to zero-valent copper.

17. The method for producing a composite body of any one of Claims 14 to 16, wherein the sputtering layer further comprises at least one additive element selected from a group consisting of silver, gold, cadmium, tin, aluminum, boron, gallium, zinc, titanium, and silicon.

18. The method for producing a composite body of Claim 15 or 16, further comprising a copper oxidation treatment step of oxidizing at least a part of the copper in the sputtering layer to monovalent copper and/or divalent copper, after the sputtering layer formation step and before the metal-ion-substituted cation exchange substance application step.

19. The method for producing a composite body of Claim 18, further comprising a partial reduction step of partially reducing the monovalent copper and/or the divalent copper oxidized in the copper oxidation treatment step to zero-valent copper and/or monovalent copper before the metal-ion-substituted cation exchange substance application step.

20. The method for producing a composite body of Claim 17, wherein the sputtering layer formation step comprises: a copper sputtering layer formation step of forming a copper sputtering layer, which is a sputtering layer containing copper; and an additive element sputtering layer formation step of forming an additive element sputtering layer, which is a sputtering layer containing the additive element.
